# EUROPEAN PATENT APPLICATION

(11) **EP 2 337 084 A2**
(43) Date of publication of application: **22.06.2011**
(21) Application number: 10194274.6
(22) Date of filing: 09.12.2010
(51) Int. Cl.: H01L 31/0296, H01L 31/18, C23C 14/06, C23C 14/34

(54) **Graded Alloy Telluride Layer In Cadmium Telluride Thin Film Photovoltaic Devices And Methods Of Manufacturing The Same**

(30) Priority: 16.12.2009 US 639073
(71) Applicant: PrimeStar Solar, Inc, Arvada, CO 80004 (US)
(72) Inventor: Feldmann-Peabody, Scott Daniel, Arvada, CO 80004 (US)
(74) Representative: Bedford, Grant Richard

(57) **Abstract**

Cadmium telluride thin film photovoltaic devices 10 are generally disclosed including a graded alloy telluride layer 22. The device can include a cadmium sulfide layer 18, a graded alloy telluride layer 22 on the cadmium sulfide layer 18, and a back contact 24 on the graded alloy telluride layer 22. The graded alloy telluride layer 22 generally has an increasing alloy concentration and decreasing cadmium concentration extending in a direction from the cadmium sulfide layer 18 towards the back contact layer 24. The device 10 may also include a cadmium telluride layer 20 between the cadmium sulfide layer 18 and the graded alloy telluride layer 22. Methods are also generally disclosed for manufacturing a cadmium telluride based thin film photovoltaic device having a graded cadmium telluride structure.

## Description

The subject matter disclosed herein relates generally to cadmium telluride thin film photovoltaic devices and methods of their manufacture. More particularly, the subject matter disclosed herein relates to cadmium telluride thin film photovoltaic devices having a graded alloy telluride layer on a cadmium telluride layer.

Thin film photovoltaic (PV) modules (also referred to as "solar panels") based on cadmium telluride (CdTe) paired with cadmium sulfide (CdS) as the photo-reactive components are gaining wide acceptance and interest in the industry. CdTe is a semiconductor material having characteristics particularly suited for conversion of solar energy to electricity. For example, CdTe has an energy bandgap of about 1.45 eV, which enables it to convert more energy from the solar spectrum as compared to lower bandgap semiconductor materials historically used in solar cell applications (e.g., about 1.1 eV for silicon). Also, CdTe converts radiation energy in lower or diffuse light conditions as compared to the lower bandgap materials and, thus, has a longer effective conversion time over the course of a day or in cloudy conditions as compared to other conventional materials.

The junction of the n-type layer and the p-type layer is generally responsible for the generation of electric potential and electric current when the CdTe PV module is exposed to light energy, such as sunlight. Specifically, the cadmium telluride (CdTe) layer and the cadmium sulfide (CdS) form a p-n heterojunction, where the CdTe layer acts as a p-type layer (i.e., a positive, electron accepting layer) and the CdS layer acts as a n-type layer (i.e., a negative, electron donating layer). Free carrier pairs are created by light energy and then separated by the p-n heterojunction to produce an electrical current.

However, one problem with CdTe PV devices is that metal electrodes make a poor contact with the cadmium telluride layer. This contact problem can lead to significantly reduced energy conversion efficiency in the device, and can lead to an increased rate of deterioration of the device.

Thus, a need exists for cadmium telluride photovoltaic devices having improved energy conversion efficiency and/or device lifetime through improved contact between the back contact and the cadmium telluride layer, as well as practical, inexpensive methods for making such cells.

Various aspects and advantages of the invention will be set forth in part in the following description, or may be clear from the description, or may be learned through practice of the invention.

Cadmium telluride thin film photovoltaic devices are generally disclosed including a graded alloy telluride layer. The device can include a cadmium sulfide layer, a graded alloy telluride layer on the cadmium sulfide layer, and a back contact on the graded alloy telluride layer. The graded alloy telluride layer generally has an increasing alloy concentration and decreasing cadmium concentration extending in a direction from the cadmium sulfide layer towards the back contact layer. In particular embodiments, the device can further include a cadmium telluride layer between the cadmium sulfide layer and the graded alloy telluride layer.

Methods are also generally disclosed for manufacturing a cadmium telluride based thin film photovoltaic device having a graded cadmium telluride structure. In one method embodiment, a plurality of alloy telluride layers step-wise can be formed directly on a cadmium sulfide layer such that the plurality of alloy telluride layers have an increasing alloy content and decreasing cadmium content as the layers extend away from the cadmium sulfide layer. The plurality of alloy telluride layers can then be annealed to form a single graded alloy telluride layer directly on the cadmium sulfide layer. A back contact layer can be formed on the graded alloy telluride layer. According to another method embodiment, a graded alloy telluride layer can be formed directly on a cadmium telluride layer such that the graded alloy telluride layer has an increasing alloy concentration and decreasing cadmium concentration extending away from the cadmium telluride layer. The graded alloy telluride layer and the cadmium telluride layer can be annealed, and a back contact layer can be formed on the graded alloy telluride layer.

Various features, aspects and advantages of the present invention will become better understood with reference to the following description and appended claims. The accompanying drawings, which are incorporated in and constitute a part of this specification, illustrate embodiments of the invention and, together with the description, serve to explain the principles of the invention, in which:
Fig. 1 shows a general schematic of a cross-sectional view of an exemplary cadmium telluride thin film photovoltaic device according to one embodiment of the present invention;
Fig. 2 shows an exemplary embodiment of a graded alloy telluride layer defined by a single layer having increasing alloy concentration and decreasing cadmium concentration through the thickness of the graded alloy telluride layer extending from the cadmium telluride layer to the back contact layer(s);
Fig. 3 shows another exemplary embodiment of a graded alloy telluride layer formed step-wise such that a plurality of layers of increasing alloy content define the graded alloy telluride layer;
Fig. 4 shows yet another exemplary embodiment of a graded alloy telluride layer formed from digital layers of alternating CdTe layers and (alloy)Te layers where the CdTe layers decrease in thickness as the (alloy)Te layers increase in thickness through the thickness of the graded alloy telluride layer extending from the cadmium telluride layer to the back contact layer(s);
Fig. 5 shows an exemplary embodiment where a single graded alloy telluride layer is between the cadmium sulfide layer and the back contact layer(s), without a separate and distinct cadmium telluride layer; and,
Fig. 6 shows a flow diagram of an exemplary method of manufacturing a photovoltaic module including a cadmium telluride thin film photovoltaic device.

Repeat use of reference characters in the present specification and drawings is intended to represent the same or analogous features or elements.

Reference now will be made in detail to embodiments of the invention, one or more examples of which are illustrated in the drawings. Each example is provided by way of explanation of the invention, not limitation of the invention. In fact, it will be apparent to those skilled in the art that various modifications and variations can be made in the present invention without departing from the scope or spirit of the invention. For instance, features illustrated or described as part of one embodiment can be used with another embodiment to yield a still further embodiment. Thus, it is intended that the present invention covers such modifications and variations as come within the scope of the appended claims and their equivalents.

In the present disclosure, when a layer is being described as "on" or "over" another layer or substrate, it is to be understood that the layers can either be directly contacting each other or have another layer or feature between the layers. Thus, these terms are simply describing the relative position of the layers to each other and do not necessarily mean "on top of" since the relative position above or below depends upon the orientation of the device to the viewer. Additionally, although the invention is not limited to any particular film thickness, the term "thin" describing any film layers of the photovoltaic device generally refers to the film layer having a thickness less than about 10 micrometers ("microns" or "µm").

It is to be understood that the ranges and limits mentioned herein include all ranges located within the prescribed limits (i.e., subranges). For instance, a range from about 100 to about 200 also includes ranges from 110 to 150, 170 to 190, 153 to 162, and 145.3 to 149.6. Further, a limit of up to about 7 also includes a limit of up to about 5, up to 3, and up to about 4.5, as well as ranges within the limit, such as from about 1 to about 5, and from about 3.2 to about 6.5.

Generally speaking, cadmium telluride thin film photovoltaic devices are presently disclosed having a graded alloy telluride layer, along with methods of its manufacture. The graded alloy telluride layer can be between a cadmium sulfide layer and the back contact layer(s). For example, the graded alloy telluride layer can be directly on the cadmium sulfide layer in place of a cadmium telluride layer. In this embodiment, the surface of the graded alloy telluride layer facing the cadmium sulfide layer can define a cadmium telluride surface. Alternatively, the graded alloy telluride layer can be directly on a cadmium telluride layer. The graded alloy telluride layer generally has an increasing alloy concentration and decreasing cadmium concentration extending from the cadmium telluride layer towards the back contact layer.

The graded alloy telluride layer can raise the bandgap of the cadmium telluride layer, thus improving the current collection of the device through formation of an electric field throughout the device, instead of just at the p-n junction (i.e., the CdS/CdTe junction). Additionally, the graded alloy telluride layer can improve contact between the cadmium telluride layer and the back contact layer(s) to increase the current collection of the device. Thus, the graded alloy telluride layer can allow for simultaneous high doping levels of the cadmium telluride layer and good current collection from the cadmium telluride layer.

The alloy of the graded alloy telluride layer can include Zn-, Mg-, or Mn-, or combinations. In particular embodiments, the graded alloy telluride layer can include a zinc telluride graded structure (e.g., CdₓZn₁₋ₓTe, where 0 < x < 1). The graded alloy telluride layer can include a dopant(s) or can be undoped.

The thickness of the graded alloy telluride layer can be configured to adjust and tailor the interaction and/or electrical field between the cadmium telluride layer and the graded alloy telluride layer. When substituted for a cadmium telluride layer, the graded alloy telluride layer can be a thin film layer (e.g., having a thickness from about 1 µm to about 5 µm). Alternatively, when on a cadmium telluride layer, the thickness of the graded alloy telluride layer can be less than the thickness of the cadmium telluride layer. In most embodiments, the thickness of the graded alloy telluride layer can be between about 0.01 µm and about 1 µm, for example between about 10 nm to about 500 nm or from about 50 nm to about 250 nm.

The graded alloy telluride layer can be included in any cadmium telluride device that utilizes a cadmium telluride layer, such as in the cadmium telluride thin film photovoltaic device disclosed in U.S. Publication No. 2009/0194165 of Murphy, et al. titled "Ultra-high Current Density Cadmium Telluride Photovoltaic Modules."

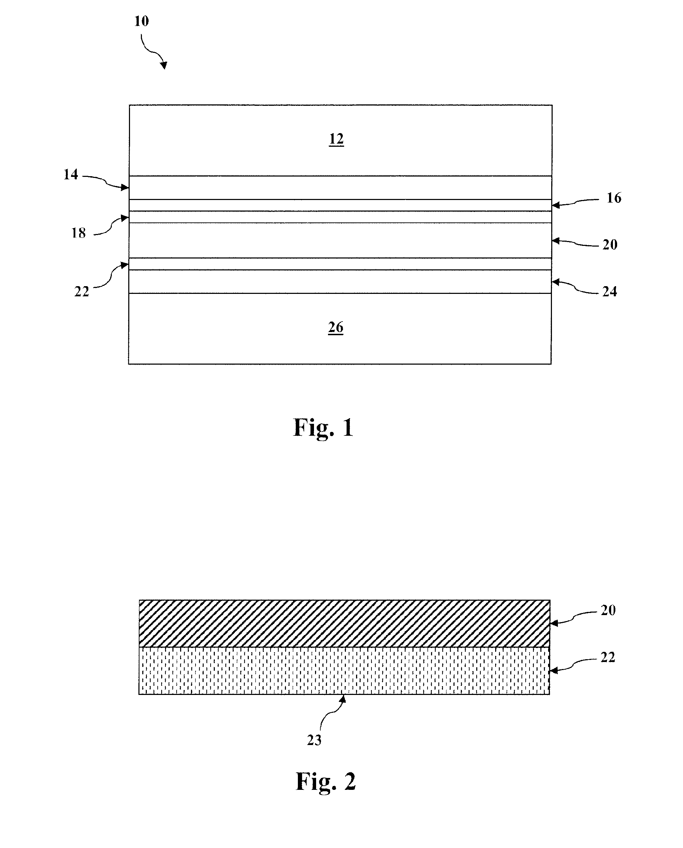

Fig. 1 represents an exemplary cadmium telluride thin film photovoltaic device 10 having a graded alloy telluride layer 22 positioned between a cadmium telluride layer 20 and a back contact layer 24. The exemplary device 10 of Fig. 1 includes a top sheet of glass 12 employed as the substrate. In this embodiment, the glass 12 can be referred to as a "superstrate", as it is the substrate on which the subsequent layers are formed even though it faces upward to the radiation source (e.g., the sun) when the cadmium telluride thin film photovoltaic device 10 is in used. The top sheet of glass 12 can be a high-transmission glass (e.g., high transmission borosilicate glass), low-iron float glass, or other highly transparent glass material. The glass is generally thick enough to provide support for the subsequent film layers (e.g., from about 0.5 mm to about 10 mm thick), and is substantially flat to provide a good surface for forming the subsequent film layers. In one embodiment, the glass 12 can be a low iron float glass containing less than about 0.15% by weight iron (Fe), and may have a transmissiveness of about 0.9 or greater in the spectrum of interest (e.g., wavelengths from about 300 nm to about 900 nm).

A transparent conductive oxide (TCO) layer 14 is shown on the glass 12 of the exemplary device 10 of Fig. 1. The TCO layer 14 allows light to pass through with minimal absorption while also allowing electric current produced by the device 10 to travel sideways to opaque metal conductors (not shown). For instance, the TCO layer 14 can have a sheet resistance less than about 30 ohm per square, such as from about 4 ohm per square to about 20 ohm per square (e.g., from about 8 ohm per square to about 15 ohm per square). The TCO layer 14 generally includes at least one conductive oxide, such as tin oxide, zinc oxide, or indium tin oxide, or mixtures thereof. Additionally, the TCO layer 14 can include other conductive, transparent materials. The TCO layer 14 can also include zinc stannate and/or cadmium stannate.

The TCO layer 14 can be formed by sputtering, chemical vapor deposition, spray pyrolysis, or any other suitable deposition method. In one particular embodiment, the TCO layer 14 can be formed by sputtering (e.g., DC sputtering or RF sputtering) on the glass 12. For example, a cadmium stannate layer can be formed by sputtering a hot-pressed target containing stoichiometric amounts of SnO₂ and CdO onto the glass 12 in a ratio of about 1 to about 2. The cadmium stannate can alternatively be prepared by using cadmium acetate and tin (II) chloride precursors by spray pyrolysis.

In certain embodiments, the TCO layer 14 can have a thickness between about 0.1 µm and about 1 µm, for example from about 0.1 µm to about 0.5 µm, such as from about 0.25 µm to about 0.35 µm. Suitable flat glass substrates having a TCO layer 14 formed on the superstrate surface can be purchased commercially from various glass manufactures and suppliers. For example, a particularly suitable glass 12 including a TCO layer 14 includes TEC 15 glass commercially available under the name TEC 15 TCO from Pilkington North America Inc. (Toledo, Ohio), which includes a TCO layer having a sheet resistance of 15 ohms per square.

A resistive transparent buffer layer 16 (RTB layer) is shown on the TCO layer 14 on the exemplary cadmium telluride thin film photovoltaic device 10 of Fig. 1. The RTB layer 16 is generally more resistive than the TCO layer 14 and can help protect the device 10 from chemical interactions between the TCO layer 14 and the subsequent layers during processing of the device 10. For example, in certain embodiments, the RTB layer 16 can have a sheet resistance that is greater than about 1000 ohms per square, such as from about 10 kOhms per square to about 1000 MOhms per square. The RTB layer 16 can also have a wide optical bandgap (e.g., greater than about 2.5 eV, such as from about 2.7 eV to about 3.0 eV).

Without wishing to be bound by a particular theory, it is believed that the presence of the RTB layer 16 between the TCO layer 14 and the cadmium sulfide layer 18 can allow for a relatively thin cadmium sulfide layer 18 to be included in the device 10 by reducing the possibility of interface defects (i.e., "pinholes" in the cadmium sulfide layer 18) creating shunts between the TCO layer 14 and the cadmium telluride layer 20. Thus, it is believed that the RTB layer 16 allows for improved adhesion and/or interaction between the TCO layer 14 and the cadmium telluride layer 20, thereby allowing a relatively thin cadmium sulfide layer 18 to be formed thereon without significant adverse effects that would otherwise result from such a relatively thin cadmium sulfide layer 18 formed directly on the TCO layer 14.

The RTB layer 16 can include, for instance, a combination of zinc oxide (ZnO) and tin oxide (SnO₂), which can be referred to as a zinc tin oxide layer ("ZTO"). In one particular embodiment, the RTB layer 16 can include more tin oxide than zinc oxide. For example, the RTB layer 16 can have a composition with a stoichiometric ratio of ZnO/SnO₂ between about 0.25 and about 3, such as in about an one to two (1:2) stoichiometric ratio of tin oxide to zinc oxide. The RTB layer 16 can be formed by sputtering, chemical vapor deposition, spraying pryolysis, or any other suitable deposition method. In one particular embodiment, the RTB layer 16 can be formed by sputtering (e.g., DC sputtering or RF sputtering) on the TCO layer 14. For example, the RTB layer 16 can be deposited using a DC sputtering method by applying a DC current to a metallic source material (e.g., elemental zinc, elemental tin, or a mixture thereof) and sputtering the metallic source material onto the TCO layer 14 in the presence of an oxidizing atmosphere (e.g., O₂ gas). When the oxidizing atmosphere includes oxygen gas (i.e., O₂), the atmosphere can be greater than about 95% pure oxygen, such as greater than about 99%.

In certain embodiments, the RTB layer 16 can have a thickness between about 0.075 µm and about 1 µm, for example from about 0.1 µm to about 0.5 µm. In particular embodiments, the RTB layer 16 can have a thickness between about 0.08 µm and about 0.2 µm, for example from about 0.1 µm to about 0.15 µm.

A cadmium sulfide layer 18 is shown on RTB layer 16 of the exemplary device 10 of Fig. 1. The cadmium sulfide layer 18 is a n-type layer that generally includes cadmium sulfide (CdS) but may also include other materials, such as zinc sulfide, cadmium zinc sulfide, etc., and mixtures thereof as well as dopants and other impurities. In one particular embodiment, the cadmium sulfide layer may include oxygen up to about 25% by atomic percentage, for example from about 5% to about 20% by atomic percentage. The cadmium sulfide layer 18 can have a wide band gap (e.g., from about 2.25 eV to about 2.5 eV, such as about 2.4 eV) in order to allow most radiation energy (e.g., solar radiation) to pass. As such, the cadmium sulfide layer 18 is considered a transparent layer on the device 10.

The cadmium sulfide layer 18 can be formed by sputtering, chemical vapor deposition, chemical bath deposition, and other suitable deposition methods. In one particular embodiment, the cadmium sulfide layer 18 can be formed by sputtering (e.g., direct current (DC) sputtering or radio frequency (RF) sputtering) on the RTB layer 16. Sputtering deposition generally involves ejecting material from a target, which is the material source, and depositing the ejected material onto the substrate to form the film. DC sputtering generally involves applying a current to a metal target (i.e., the cathode) positioned near the substrate (i.e., the anode) within a sputtering chamber to form a direct-current discharge. The sputtering chamber can have a reactive atmosphere (e.g., an oxygen atmosphere, nitrogen atmosphere, fluorine atmosphere) that forms a plasma field between the metal target and the substrate. The pressure of the reactive atmosphere can be between about 1 mTorr and about 20 mTorr for magnetron sputtering. When metal atoms are released from the target upon application of the voltage, the metal atoms can react with the plasma and deposit onto the surface of the substrate. For example, when the atmosphere contains oxygen, the metal atoms released from the metal target can form a metallic oxide layer on the substrate. The current applied to the source material can vary depending on the size of the source material, size of the sputtering chamber, amount of surface area of substrate, and other variables. In some embodiments, the current applied can be from about 2 amps to about 20 amps.

Conversely, RF sputtering generally involves exciting a capacitive discharge by applying an alternating-current (AC) or radio-frequency (RF) signal between the target (e.g., a ceramic source material) and the substrate. The sputtering chamber can have an inert atmosphere (e.g., an argon atmosphere) having a pressure between about 1 mTorr and about 20 mTorr.

Due to the presence of the RTB layer 16, the cadmium sulfide layer 18 can have a thickness that is less than about 0.1 µm, such as between about 10 nm and about 100 nm, such as from about 50 nm to about 80 nm, with a minimal presence of pinholes between the TCO layer 14 and the cadmium sulfide layer 18. Additionally, a cadmium sulfide layer 18 having a thickness less than about 0.1 µm reduces any absorption of radiation energy by the cadmium sulfide layer 18, effectively increasing the amount of radiation energy reaching the underlying cadmium telluride layer 22.

A cadmium telluride layer 20 is shown on the cadmium sulfide layer 18 in the exemplary cadmium telluride thin film photovoltaic device 10 of Fig. 1. The cadmium telluride layer 20 is a p-type layer that generally includes cadmium telluride (CdS) but may also include other materials. As the p-type layer of device 10, the cadmium telluride layer 20 is the photovoltaic layer that interacts with the cadmium sulfide layer 18 (i.e., the n-type layer) to produce current from the absorption of radiation energy by absorbing the majority of the radiation energy passing into the device 10 due to its high absorption coefficient and creating electron-hole pairs. For example, the cadmium telluride layer 20 can generally be formed from cadmium telluride and can have a bandgap tailored to absorb radiation energy (e.g., from about 1.4 eV to about 1.5 eV, such as about 1.45 eV) to create electron-hole pairs upon absorption of the radiation energy. Holes may travel from the p-type side (i.e., the cadmium telluride layer 20) across the junction to the n-type side (i.e., the cadmium sulfide layer 18) and, conversely, electrons may pass from the n-type side to the p-type side. Thus, the p-n junction formed between the cadmium sulfide layer 18 and the cadmium telluride layer 20 forms a diode-like material that allows conventional current to flow in only one direction to create a charge imbalance across the boundary. This charge imbalance leads to the creation of an electric field spanning the p-n junction and separating the freed electrons and holes.

The cadmium telluride layer 20 can be formed by any known process, such as chemical vapor deposition (CVD), spray pyrolysis, electro-deposition, sputtering, close-space sublimation (CSS), etc. In one particular embodiment, the cadmium sulfide layer 18 is deposited by a sputtering and the cadmium telluride layer 20 is deposited by close-space sublimation. In particular embodiments, the cadmium telluride layer 20 can have a thickness between about 0.1 µm and about 10 µm, such as from about 1 µm and about 5 µm. In one particular embodiment, the cadmium telluride layer 20 can have a thickness between about 2 µm and about 4 µm, such as about 3 µm.

The graded alloy telluride layer 22 is shown on the cadmium telluride layer 20 between the cadmium telluride layer 20 and the back contact layer 24. The graded alloy telluride layer generally defines a region having an increasing alloy concentration and decreasing cadmium concentration through the thickness of the graded alloy telluride layer 22 extending from the cadmium telluride layer 20 to the back contact layer(s) 24. For example, the graded alloy telluride layer can be represented as a Cd₁₋ₓ(alloy)ₓTe layer, where 0 < x < 1, with increasing alloy content (i.e., increasing the value of x) through the thickness of the graded alloy telluride layer extending from the cadmium telluride layer to the back contact layer(s).

Fig. 2 shows one embodiment of a graded alloy telluride layer 22 defined by a single layer having increasing alloy concentration and decreasing cadmium concentration through the thickness of the graded alloy telluride layer 22 extending from the cadmium telluride layer 20 to the back contact layer(s) 24. In one particular embodiment, the junction of the cadmium telluride layer 20 and the graded alloy telluride layer 22 is primarily CdTe (i.e., Cd₁₋ₓ(alloy)ₓTe, where x is about 0), and the surface 23 of the graded alloy telluride layer 22, which will contact the back contact layer 24, is substantially free from cadmium (e.g., Cd₁₋ₓ(alloy)ₓTe, where x is about 1).

In one embodiment, the increasing alloy concentration and decreasing cadmium concentration may be a linear change (i.e., a substantially constant rate of change) through the thickness of the graded alloy telluride layer 22 extending from the cadmium telluride layer 20 to the back contact layer(s) 24. Alternatively, the rate of increasing alloy concentration and decreasing cadmium concentration may be varied throughout the graded alloy telluride layer 22. For example, the rate of increasing alloy concentration and decreasing cadmium concentration may be relatively slow (e.g., x increasing to about 0.25 or less, such as x increasing to about 0.05 to about 0.2) through the first half of the thickness, while the rate of increasing alloy concentration and decreasing cadmium concentration may be relatively fast through the second half of the thickness. Conversely, the rate of increasing alloy concentration and decreasing cadmium concentration may be relatively fast (e.g., x increasing to about 0.75 or more, such as x increasing to about 0.8 to about 0.95) through the first half of the thickness, while the rate of increasing alloy concentration and decreasing cadmium concentration may be relatively slow through the second half of the thickness.

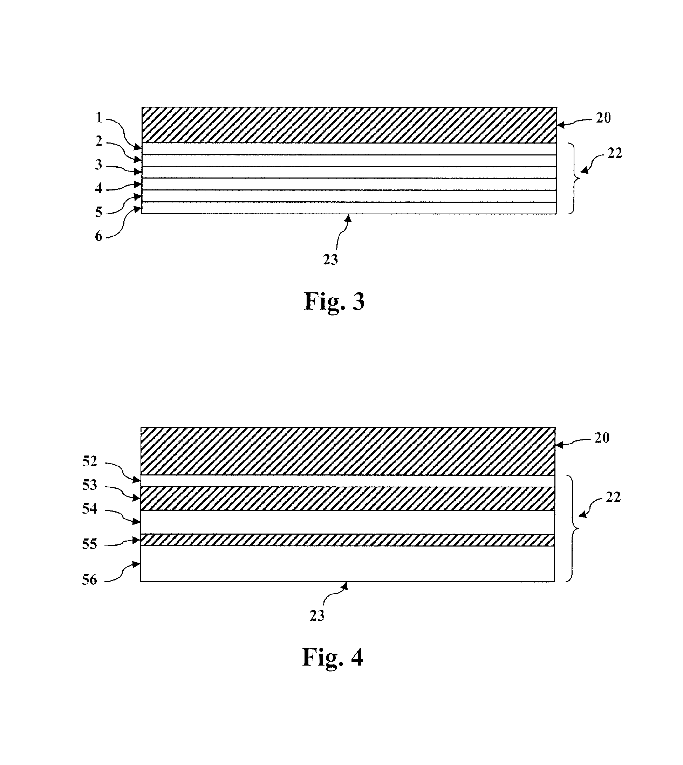

Fig. 3 shows another embodiment of a graded alloy telluride layer 22 includes a plurality of layers of increasing alloy content (layers 1-6, respectively) formed step-wise to collectively define the graded alloy telluride layer 22. Each individual layer 1-6 has an increasing alloy content and decreasing cadmium content, such that layer 2 has more alloy content and less cadmium content than layer 1, layer 3 has more alloy content and less cadmium content than layer 2, layer 4 has more alloy content and less cadmium content than layer 3, layer 5 has more alloy content and less cadmium content than layer 4, and layer 6 has more alloy content and less cadmium content than layer 5. For instance, layer 1 can have a structure of Cd₁₋ₓ(alloy)ₓTe, where 0 < x ≤ 0.2; layer 2 can have a structure of Cd₁₋ₓ(alloy)ₓTe, where 0.2 ≤ x ≤ 0.4; layer 3 can have a structure of Cd₁₋ₓ(alloy)ₓTe, where 0.4 ≤ x ≤ 0.6; layer 4 can have a structure of Cd₁₋ₓ(alloy)ₓTe, where 0.6 ≤ x ≤ 0.8; layer 5 can have a structure of Cd₁-ₓ(alloy)ₓTe, where 0.8 ≤ x < 1; and layer 6 can have a structure of Cd₁₋ₓ(alloy)ₓTe, where x is about 1. As such, in one particular embodiment, the junction of the cadmium telluride layer 20 and the layer 1 is primarily CdTe (i.e., Cd₁₋ₓ(alloy)ₓTe, where x is 0), and the surface 23 of the graded alloy telluride layer 22, which will contact the back contact layer 24, is substantially free from cadmium (e.g., Cd₁₋ₓ(alloy)ₓTe, where x is 1). Although the exemplary step-wise graded alloy telluride layer 22 shown in Fig. 3 has six layers 1-6, any number of step-wise layers can be used to form the graded alloy telluride layer 22. Additionally, each of the layers 1-6 can be formed of varying thickness, such as from about 1 nm to about 250 nm in thickness. In certain embodiments, the thickness of each of the layers 1-6 can be from about 10 nm to about 100 nm, for example from about 10 nm to about 50 nm. In one embodiment, each of the layers 1-6 can have substantially the same thickness.

Fig. 4 shows yet another embodiment of a graded alloy telluride layer 22 formed from digital layers of alternating CdTe layers 53, 55 and (alloy)Te layers 52, 54, 56 with the CdTe layers 52, 54 decreasing in thickness as the (alloy)Te layers 52, 54, 56 increase in thickness through the thickness of the graded alloy telluride layer 22 extending from the cadmium telluride layer 20 to the back contact layer(s) 24. In one particular embodiment, each of the cadmium telluride digital layers includes Cd₁₋ₓ(alloy)ₓTe, where 0 ≤ x ≤ 0.1, and each of the alloy telluride digital layers includes Cd₁₋ₓ(alloy)ₓTe, where 0.9 ≤ x ≤ 1. For instance, each of the CdTe layers 53, 55 are primary CdTe (i.e., Cd₁₋ₓ(alloy)ₓTe, where x is 0), and each of the (alloy)Te layers 52, 54, 56 is substantially free from cadmium (e.g., Cd₁₋ₓ(alloy)ₓTe, where x is 1). As such, the digital layers of alternating CdTe layers 53, 55 and (alloy)Te layers 52, 54, 56 with the CdTe layers 53, 55 decreasing in thickness as the (alloy)Te layers 52, 54, 56 increase in thickness through the thickness of the graded alloy telluride layer 22 form a graded structure where the alloy concentration increases and the cadmium concentration decreases through the thickness of the graded alloy telluride layer 22 extending from the cadmium telluride layer 20 to the back contact layer(s) 24. Although shown with five digital layers (i.e., first CdTe layer 52 and second CdTe layer 54 in combination with first (alloy)Te layer 52, second (alloy)Te layer 54, and third (alloy)Te layer 56), any number of digital layers can be used to form the graded alloy telluride layer 22.

A series of post-forming treatments can be applied to the exposed surface of the cadmium telluride layer 20, before and/or after formation of the graded alloy telluride layer 22. These treatments can tailor the functionality of the cadmium telluride layer 20 and prepare its surface for subsequent adhesion to the back contact layer(s) 24. For example, the cadmium telluride layer 20 can be annealed at elevated temperatures (e.g., from about 350° C to about 500° C, such as from about 375° C to about 424° C) for a sufficient time (e.g., from about 1 to about 10 minutes) to create a quality p-type layer of cadmium telluride. Without wishing to be bound by theory, it is believed that annealing the cadmium telluride layer 20 (and the device 10) converts the normally n-type cadmium telluride layer 20 to a p-type cadmium telluride layer 20 having a relatively low resistivity. The cadmium telluride layer 20 can also recrystallize and undergo grain growth during annealing.

Annealing the cadmium telluride layer 20 can be carried out in the presence of cadmium chloride in order to dope the cadmium telluride layer 20 with chloride ions. For example, the cadmium telluride layer 20 can be washed with an aqueous solution containing cadmium chloride and then annealed at the elevated temperature. In one embodiment, particularly when the graded alloy telluride layer 22 is formed from a single layer as shown in Fig. 2, the cadmium telluride layer 20 and graded alloy telluride layer 22 can be annealed less severely, such as from about 150° C to about 350° C, such as from about 200° C to about 300° C, for less than 5 minutes, such as from about 30 seconds to about 3 minutes. Without wishing to be bound by theory, it is believed that the less severe anneal while form the graded structure without completely diffusing the alloy telluride layer into the cadmium telluride layer.

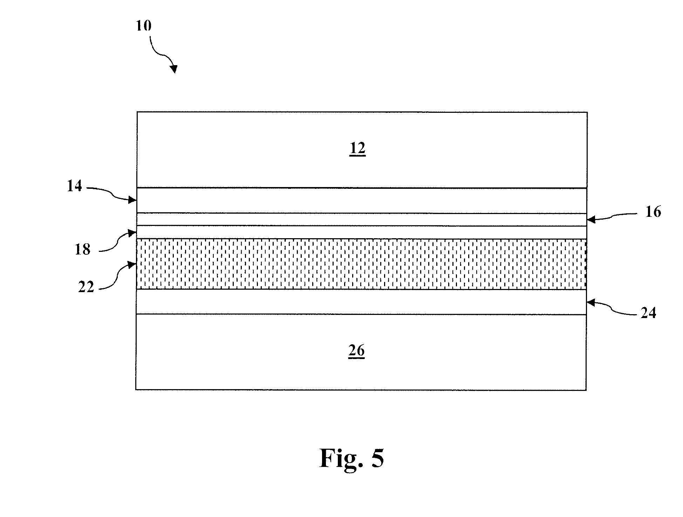

In another embodiment, such as shown in Fig. 5, a single graded alloy telluride layer 22 can be formed by annealing a series of step-wise layers of increasing alloy content (e.g., layers 21a-21f shown in Fig. 3) at sufficient temperatures to merge the step-wise layers into a single graded alloy telluride layer 22. For example, a series of step-wise layers of increasing alloy content can be annealed at elevated temperatures (e.g., from about 350° C to about 500° C, such as from about 375° C to about 424° C) for a sufficient time (e.g., from about 5 minutes to about 1 hour, such as from about 10 minutes to about 45 minutes) to form the single graded alloy telluride layer 22. As such, the single graded alloy telluride layer 22 can define a single layer having increasing alloy concentration and decreasing cadmium concentration through the thickness of the graded alloy telluride layer extending from the cadmium sulfide layer 18 to the back contact layer(s) 24. Thus, in this embodiment, the graded alloy telluride layer 22 can define a single layer positioned directly on the cadmium sulfide layer 18 (i.e., without a separate and distinct cadmium telluride layer present in the device 10), where the surface of the graded alloy telluride layer 22 closest to the cadmium sulfide layer 18 is defined by cadmium telluride (e.g., less than 10% by mole fraction alloy concentration at the surface, such as less than 5% by mole fraction).

In one particular embodiment, after annealing the cadmium telluride layer 20 in the presence of cadmium chloride, the surface can be washed to remove any cadmium oxide formed on the surface. This surface preparation can leave a Te-rich surface on the cadmium telluride layer 20 by removing cadmium oxide from the surface. For instance, the surface can be washed with a suitable solvent (e.g., ethylenediamine also known as 1,2 diaminoethane or "DAE") to remove any cadmium oxide from the surface.

Additionally, copper can be added to the cadmium telluride layer 20. Along with a suitable etch, the addition of copper to the cadmium telluride layer 20 can form a surface of copper-telluride on the cadmium telluride layer 20 in order to obtain a low-resistance electrical contact between the cadmium telluride layer 20 (i.e., the p-type layer) and the back contact layer(s). Specifically, the addition of copper can create a surface layer of cuprous telluride (Cu₂Te) between the cadmium telluride layer 20 and the back contact layer 24. Thus, the Te-rich surface of the cadmium telluride layer 20 can enhance the collection of current created by the device through lower resistivity between the cadmium telluride layer 20 and the back contact layer 24.

Copper can be applied to the exposed surface of the cadmium telluride layer 20 by any process. For example, copper can be sprayed or washed on the surface of the cadmium telluride layer 20 in a solution with a suitable solvent (e.g., methanol, water, acetate, or the like, or combinations thereof) followed by annealing. In particular embodiments, the copper may be supplied in the solution in the form of copper chloride. The annealing temperature is sufficient to allow diffusion of the copper ions into the cadmium telluride layer 20, such as from about 125° C to about 300° C (e.g. from about 150° C to about 200° C) for about 5 minutes to about 30 minutes, such as from about 10 to about 25 minutes.

A back contact layer 24 is shown on the cadmium telluride layer 20. The back contact layer 24 generally serves as the back electrical contact, in relation to the opposite, TCO layer 14 serving as the front electrical contact. The back contact layer 24 can be formed on, and in one embodiment is in direct contact with, the cadmium telluride layer 20. The back contact layer 24 is suitably made from one or more highly conductive materials, such as elemental nickel, chromium, copper, tin, aluminum, gold, silver, or technetium, or alloys or mixtures thereof. Additionally, the back contact layer 24 can be a single layer or can be a plurality of layers. In one particular embodiment, the back contact layer 24 can include graphite, such as a layer of carbon deposited on the p-layer followed by one or more layers of metal, such as the metals described above. The back contact layer 24, if made of or comprising one or more metals, is suitably applied by a technique such as sputtering or metal evaporation. If it is made from a graphite and polymer blend, or from a carbon paste, the blend or paste is applied to the semiconductor device by any suitable method for spreading the blend or paste, such as screen printing, spraying or by a "doctor" blade. After the application of the graphite blend or carbon paste, the device can be heated to convert the blend or paste into the conductive back contact layer. A carbon layer, if used, can be from about 0.1 µm to about 10 µm in thickness, for example from about 1 µm to about 5 µm. A metal layer of the back contact, if used for or as part of the back contact layer 24, can be from about 0.1 µm to about 1 µm in thickness.

The encapsulating glass 26 is also shown in the exemplary cadmium telluride thin film photovoltaic device 10 of Fig. 1.

Other components (not shown) can be included in the exemplary device 10, such as bus bars, external wiring, laser etches, etc. For example, when the device 10 forms a photovoltaic cell of a photovoltaic module, a plurality of photovoltaic cells can be connected in series in order to achieve a desired voltage, such as through an electrical wiring connection. Each end of the series connected cells can be attached to a suitable conductor, such as a wire or bus bar, to direct the photovoltaically generated current to convenient locations for connection to a device or other system using the generated electricity. A convenient means for achieving such series connections is to laser scribe the device to divide the device into a series of cells connected by interconnects. In one particular embodiment, for instance, a laser can be used to scribe the deposited layers of the semiconductor device to divide the device into a plurality of series connected cells.

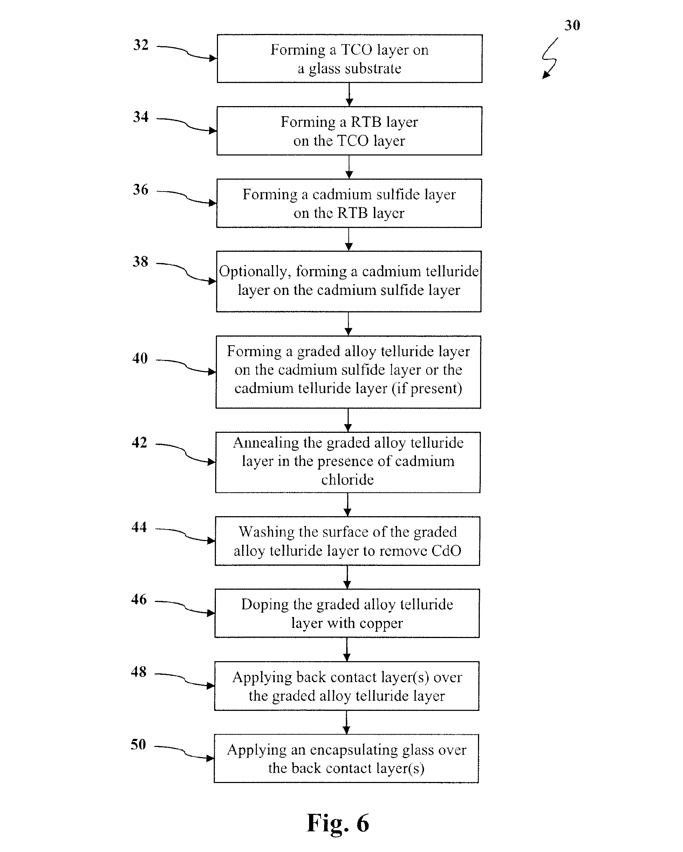

Fig. 6 shows a flow diagram of an exemplary method 30 of manufacturing a photovoltaic device according to one embodiment of the present invention. According to the exemplary method 30, a TCO layer is formed on a glass substrate at 32. At 34, a RTB layer is formed on the TCO layer. A cadmium sulfide layer is formed on the RTB layer at 36. Optionally, a cadmium telluride layer can be formed on the cadmium sulfide layer at 38. The graded alloy telluride layer can then be formed on the cadmium telluride layer (see e.g., Figs. 1-4) or directly on the cadmium sulfide layer (see e.g., Fig. 5) at 40. The graded telluride layer can be annealed in the presence of cadmium chloride at 42. The graded alloy telluride layer can then be washed at 44 to remove any CdO formed on the surface, and doped with copper at 46. At 48, back contact layer(s) can be applied over the graded alloy telluride layer, and an encapsulating glass can be applied over the back contact layer at 50.

One of ordinary skill in the art should recognize that other processing and/or treatments can be included in the method 30. For instance, the method may also include laser scribing to form electrically isolated photovoltaic cells in the device. These electrically isolated photovoltaic cells can then be connected in series to form a photovoltaic module. Also, electrical wires can be connected to positive and negative terminals of the photovoltaic module to provide lead wires to harness electrical current produced by the photovoltaic module.

This written description uses examples to disclose the invention, including the preferred mode, and also to enable any person skilled in the art to practice the invention, including making and using any devices or systems and performing any incorporated methods. The patentable scope of the invention is defined by the claims, and may include other examples that occur to those skilled in the art. Such other examples are intended to be within the scope of the claims if they include structural elements that do not differ from the literal language of the claims, or if they include equivalent structural elements with insubstantial differences from the literal languages of the claims.

Various aspects and embodiments of the present invention are defined by the following numbered clauses:
1. A cadmium telluride thin film photovoltaic device, comprising:
   a cadmium sulfide layer;
   a graded alloy telluride layer on the cadmium sulfide layer; and,
   a back contact on the graded alloy telluride layer;
   wherein the graded alloy telluride layer has an increasing alloy concentration and decreasing cadmium concentration extending in a direction from the cadmium sulfide layer towards the back contact layer.
2. The cadmium telluride thin film photovoltaic device as in clause 1, wherein the graded alloy telluride layer comprises zinc telluride, magnesium telluride, or manganese telluride, or combinations thereof.
3. The cadmium telluride thin film photovoltaic device as in any preceding clause, wherein the graded alloy telluride layer includes an alloy consisting essentially of zinc such that the graded alloy telluride layer comprises CdₓZn₁₋ₓTe, where 0 < x < 1.
4. The cadmium telluride thin film photovoltaic device as in any preceding clause, wherein the graded alloy telluride layer is doped.
5. The cadmium telluride thin film photovoltaic device as in any preceding clause, wherein the dopant comprises Cu, N, P, As, or Sb, or combinations thereof.
6. The cadmium telluride thin film photovoltaic device as in any preceding clause, wherein the graded alloy telluride layer comprises Cd₁₋ₓ(alloy)ₓTe, where x is about 0 adjacent to the cadmium telluride layer and where x is about 1 at an opposite surface at the back contact layer.
7. The cadmium telluride thin film photovoltaic device as in any preceding clause, where the graded alloy telluride layer defines a single layer positioned directly on the cadmium sulfide layer.
8. The cadmium telluride thin film photovoltaic device as in any preceding clause further comprising a cadmium telluride layer between the cadmium sulfide layer and the graded alloy telluride layer.
9. The cadmium telluride thin film photovoltaic device as in any preceding clause, wherein the graded alloy telluride layer is defined by a single graded layer directly on the cadmium telluride layer.
10. The cadmium telluride thin film photovoltaic device as in any preceding clause, wherein the increasing alloy concentration and decreasing cadmium concentration is linear through the thickness of the graded alloy telluride layer extending in the direction from the cadmium sulfide layer towards the back contact layer.
11. The cadmium telluride thin film photovoltaic device as in any preceding clause, wherein the graded alloy telluride layer is formed step-wise and comprises a plurality of layers of increasing alloy content and decreasing cadmium content as the layers become closer to the back contact layer.
12. The cadmium telluride thin film photovoltaic device as in any preceding clause, wherein the graded alloy telluride layer comprises a first layer closest to the cadmium sulfide layer, a second layer on the first layer, a third layer on the second layer, a fourth layer on the third layer, and a fifth layer on the fourth layer, and wherein the second layer has more alloy content and less cadmium content than the first layer, the third layer has more alloy content and less cadmium content than second layer, the fourth layer has more alloy content and less cadmium content than third layer, the fifth layer has more alloy content and less cadmium content than fourth layer.
13. The cadmium telluride thin film photovoltaic device as in any preceding clause, wherein the first layer comprises Cd₁₋ₓ(alloy)ₓTe, where 0 ≤ x ≤ 0.2; the second layer comprises Cd₁₋ₓ(alloy)ₓTe, where 0.2 ≤ x ≤ 0.4; the third layer comprises Cd₁₋ₓ(alloy)ₓTe, where 0.4 ≤ x ≤ 0.6; the fourth layer comprises Cd₁₋ₓ(alloy)ₓTe, where 0.6 ≤ x ≤ 0.8; and the fifth layer comprises Cd₁₋ₓ(alloy)ₓTe, where 0.8 ≤ x ≤ 1.
14. The cadmium telluride thin film photovoltaic device as in any preceding clause, wherein the graded alloy telluride layer comprises alternating cadmium telluride digital layers and alloy telluride digital layers such that the cadmium telluride digital layers decrease in thickness as the alloy telluride digital layers increase in thickness through the thickness of the graded alloy telluride layer extending in the direction from the cadmium sulfide layer towards the back contact layer.
15. The cadmium telluride thin film photovoltaic device as in any preceding clause, wherein each of the cadmium telluride digital layers comprises Cd₁₋ₓ(alloy)ₓTe, where 0 ≤ x ≤ 0.1, and wherein each of the alloy telluride digital layers comprise Cd₁₋ₓ(alloy)ₓTe, where 0.9 ≤ x ≤ 1.
16. A method for manufacturing a cadmium telluride based thin film photovoltaic device having a graded cadmium telluride structure, the method comprising:
   forming a plurality of alloy telluride layers step-wise directly on a cadmium sulfide layer such that the plurality of alloy telluride layers have an increasing alloy content and decreasing cadmium content as the layers extend away from the cadmium sulfide layer.
17. A method for manufacturing a cadmium telluride based thin film photovoltaic device having a graded cadmium telluride structure, the method comprising:
   forming a graded alloy telluride layer directly on a cadmium telluride layer, wherein the graded alloy telluride layer has an increasing alloy concentration and decreasing cadmium concentration extending away from the cadmium telluride layer.
18. The method as in any preceding clause, wherein the graded alloy telluride layer is defined by a single graded layer having an increasing alloy concentration and decreasing cadmium concentration extending away from the cadmium telluride layer.
19. The method as in any preceding clause, wherein forming the graded alloy telluride layer comprises forming a plurality of layers step-wise on the cadmium telluride layer such that the plurality of layers have an increasing alloy content and decreasing cadmium content as the layers extend away from the cadmium telluride layer.
20. The method as in any preceding clause, wherein forming the graded alloy telluride layer comprises forming alternating cadmium telluride digital layers and alloy telluride digital layers on the cadmium telluride layer such that the cadmium telluride digital layers decrease in thickness as the alloy telluride digital layers increase in thickness through the thickness of the graded alloy telluride layer extending away from the cadmium telluride layer towards.

## Claims

1. A cadmium telluride thin film photovoltaic device (10), comprising:
a cadmium sulfide layer (18);
a graded alloy telluride layer (22) on the cadmium sulfide layer (18); and,
a back contact (20) on the graded alloy telluride layer (22);
wherein the graded alloy telluride layer (22) has an increasing alloy concentration and decreasing cadmium concentration extending in a direction from the cadmium sulfide layer (18) towards the back contact layer (20).

2. The cadmium telluride thin film photovoltaic device (10) as in claim 1, wherein the graded alloy telluride layer (22) comprises zinc telluride, magnesium telluride, or manganese telluride, or combinations thereof.

3. The cadmium telluride thin film photovoltaic device (10) as in any preceding claim, wherein the graded alloy telluride layer (22) includes an alloy consisting essentially of zinc such that the graded alloy telluride layer (22) comprises CdₓZn₁₋ₓTe, where 0 < x < 1.

4. The cadmium telluride thin film photovoltaic device (10) as in any preceding claim, wherein the graded alloy telluride layer (22) comprises Cd₁₋ₓ(alloy)ₓTe, where x is about 0 adjacent to the cadmium sulfide layer (18) and where x is about 1 at an opposite surface at the back contact layer (20).

5. The cadmium telluride thin film photovoltaic device (10) as in any preceding claim, where the graded alloy telluride layer (22) defines a single layer positioned directly on the cadmium sulfide layer (18).

6. The cadmium telluride thin film photovoltaic device (10) as in any preceding claim further comprising a cadmium telluride layer (20) between the cadmium sulfide layer (18) and the graded alloy telluride layer (22).

7. The cadmium telluride thin film photovoltaic device (10) as in any of the preceding claims, wherein the graded alloy telluride layer (22) is formed step-wise and comprises a plurality of layers of increasing alloy content and decreasing cadmium content as the layers become closer to the back contact layer (24).

8. The cadmium telluride thin film photovoltaic device (10) as in any preceding claim, wherein the graded alloy telluride layer (22) comprises alternating cadmium telluride digital layers and alloy telluride digital layers such that the cadmium telluride digital layers decrease in thickness as the alloy telluride digital layers increase in thickness through the thickness of the graded alloy telluride layer (22) extending in the direction from the cadmium sulfide layer (18) towards the back contact layer (24).

9. A method for manufacturing a cadmium telluride based thin film photovoltaic device (10) having a graded cadmium telluride structure as in any preceding claim, the method comprising:
forming a plurality of alloy telluride layers step-wise directly on a cadmium sulfide layer such that the plurality of alloy telluride layers have an increasing alloy content and decreasing cadmium content as the layers extend away from the cadmium sulfide layer.

10. A method for manufacturing a cadmium telluride based thin film photovoltaic device (10) having a graded cadmium telluride structure as in any of claims 1 to 8, the method comprising:
forming a graded alloy telluride layer directly on a cadmium telluride layer, wherein the graded alloy telluride layer has an increasing alloy concentration and decreasing cadmium concentration extending away from the cadmium telluride layer.
